# EUROPÄISCHE PATENTSCHRIFT

(11) **EP 3 833 929 B1**
(45) Veröffentlichungstag und Bekanntmachung des Hinweises auf die Patenterteilung: **05.10.2022**
(21) Anmeldenummer: 18765546.9
(22) Anmeldetag: 09.08.2018
(51) Int. Cl.: G01B 5/00, G01B 5/004, G01B 7/00

(54) **TAKTILES ERKENNEN EINER POSITION VON KOMPONENTEN EINES FAHRZEUGBAUTEILS**
TACTILE DETECTION OF A POSITION OF COMPONENTS OF A VEHICLE PART
DÉTECTION TACTILE D'UNE POSITION D'ÉLÉMENTS D'UN COMPOSANT DE VÉHICULE

(43) Veröffentlichungstag der Anmeldung: 16.06.2021
(73) Patentinhaber: Lisa Dräxlmaier GmbH, 84137 Vilsbiburg (DE)
(72) Erfinder: KAGERHUBER, Manuel, 84140 Gangkofen (DE); FUSSEDER, Franz, 84140 Gangkofen (DE); MAYER, Anton, 84137 Seyboldsdorf (DE)
(86) Internationale Anmeldenummer: PCT/DE2018/100703
(87) Internationale Veröffentlichungsnummer: WO 2020/030206

(56) Entgegenhaltungen:
- EP-B1- 2 044 449
- DE-A1- 3 504 606
- DE-A1-102011 102 791

## Beschreibung

### Technisches Gebiet

Die vorliegende Erfindung betrifft eine Prüfstation zum taktilen Erkennen einer Position mindestens einer Komponente eines Fahrzeugbauteils, aufweisend einen Prüfadapter zur Aufnahme des zu prüfenden Fahrzeugbauteils, eine auf einem vorgegebenen Weg gegen den Prüfadapter bewegbare Prüfsonde, wobei die Prüfsonde mindestens ein Berührelement aufweist, mittels dessen eine Berührung mit der zu prüfenden Komponente des Fahrzeugbauteils detektierbar ist und einen Antrieb zum Bewegen der Prüfsonde. Die vorliegende Erfindung betrifft auch ein System mit einer Prüfstation und einem in dem Prüfadapter befestigten zu prüfenden Fahrzeugbauteil. Die vorliegende Erfindung betrifft außerdem ein Verfahren zum taktilen Erkennen einer Position von Komponenten eines Fahrzeugbauteils. Die vorliegende Erfindung ist besonders vorteilhaft einsetzbar zum Prüfen von Steckverbindungselementen und Sicherungsbänken.

### Stand der Technik

DE 10 2006 028 923 A1 offenbart eine Prüfvorrichtung mit einem Kontaktgehäuse für eine elektrische Steckverbindung, welches mindestens eine Kontaktkammer zum Aufnehmen eines durch eine Bestücköffnung in die Kontaktkammer einsteckbaren Kontaktkörpers , einen seitlich in die Kontaktkammer hineinragenden, elastisch auslenkbaren Verrastungsarm zur Verrastung des Kontaktkörpers in seiner Endposition in der Kontaktkammer und mindestens eine Zugangsöffnung auf der der Bestückungsöffnung gegenüberliegenden Seite aufweist, mit einem durch die Zugangsöffnung in den rückseitigen Auslenkbereich des Verrastungsarms einführbaren Spacerelement und mit einem durch die Zugangsöffnung einführbaren Prüfelement zur elektrischen Kontaktierung des in der Kontaktkammer in seiner Endposition befindlichen Kontaktkörpers , wobei erfindungsgemäß das Spacerelement und das Prüfelement beide an einem Prüfadapter angeordnet sind.

EP 2 044 449 B1 betrifft einen Prüfstift für eine Prüfvorrichtung zum Prüfen von Steckern sowie eine Prüfvorrichtung unter Verwendung eines Prüfstiftes sowie ein Verfahren zum Prüfen von Steckern. Der Prüfstift weist auf: einen Nadelkörper zum Einsatz in ein verfahrbares Element der Prüfvorrichtung, und eine innerhalb des Nadelkörpers federvorgespannt aufgenommene Prüfnadel zur Anlage an einem Steckerkontakt des zu prüfenden Steckers, wobei in dem Nadelkörper ein hülsenförmiger Auflagekolben federvorgespannt längsverschiebbar aufgenommen ist, der eine Anlagefläche zur Anlage an der Steckerfrontseite des Steckergehäuses des zu prüfenden Steckers aufweist, und die Prüfnadel in dem Auflagekolben federvorgespannt längsverschiebbar aufgenommen ist. Die Prüfvorrichtung weist auf: eine Adapterplatte mit einer auf ihrer Oberseite ausgebildeten Kontur zur Aufnahme des zu prüfenden Steckers, und eine verfahrbare Ebene mit dem mindestens einen Prüfstift, wobei zur Prüfung die verfahrbare Ebene zu der Adapterplatte hin verstellbar ist und die Prüfnadel gegen einen Steckerkontakt des zu prüfenden Steckers drückt.

US 7,030,636 B1 offenbart ein Stiftprüfsystem zur effizienten Erkennung von entriegelten Klemmen in einem elektrischen Steckverbinder. Das Stiftprüfsystem umfasst: ein Gehäuse mit einer Aufnahmeöffnung zum entfernbaren Aufnehmen eines zu testenden elektrischen Steckverbinders, einer Vielzahl von Sondenkanälen innerhalb des Gehäuses, einer Vielzahl von vorgespannten Prüfsonden, die in dem Gehäuse verschiebbar positioniert sind und jeweils ein Eingriffsende aufweisen, das sich in die Aufnahmeöffnung erstreckt und einer Klemme innerhalb des elektrischen Steckverbinders zugeordnet ist, einer Vielzahl von Lichtemittern zum Leuchten von Licht durch entsprechende Lichtdurchlässe und eine Vielzahl von Lichtempfängern am entgegengesetzten Ende der Lichtdurchlässe. Die Lichtdurchlässe erstrecken sich im Wesentlichen quer durch eine Reihe der Sondenkanäle und die Prüfsonden umfassen jeweils eine Aussparung, die es ermöglicht, dass das Licht durch die Prüfsonden hindurchtritt, wenn die Prüfsonden aufgrund eines Eingriffs mit den Klemmen des elektrischen Steckverbinders bewegt werden.

DE 35 04 606 A1 offenbart ein Gerät zum Prüfen von mit Steckern versehenen Kabeln auf Verrastungsfehler, mit Kupplungselementen, die jeweils ein in ihrer Außenkontur einem bestimmten Stecker entsprechende Steckeraufnahme aufweisen.

Die EP 2 044 449 B1 offenbart betrifft einen Prüfstift für eine Prüfvorrichtung zum Prüfen von Steckern, wobei der Prüfstift aufweist: einen Nadelkörper zum Einsatz in ein verfahrbares Element der Prüfvorrichtung, und eine innerhalb des Nadelkörpers federvorgespannt aufgenommene Prüfnadel zur Anlage an einem Steckerkontakt des zu prüfenden Steckers. Um eine zuverlässige Prüfung auf Verrastungsfehler bei einer automatisierten Messung zu gewährleisten, ist vorgesehen, dass in dem Nadelkörper ein hülsenförmiger Auflagekolben federvorgespannt längsverschiebbar aufgenommen ist, der eine Anlagefläche zur Anlage an der Steckerfrontseite des Steckergehäuses des zu prüfenden Steckers aufweist, und die Prüfnadel in dem Auflagekolben federvorgespannt aufgenommen ist.

Die DE 10 2011 102 A1 zeigt eine Federkontaktstiftanordnung mit einem Federkontaktstift, der ein Stiftgehäuse aufweist, in dem ein Kontaktelement längsverschieblich gelagert und von einer entgegen einer Verschieberichtung wirkenden Federeinrichtung kraftbeaufschlagt ist, wobei das Kontaktelement mit mindestens einer ersten Schnittstelle der Federkontaktstiftanordnung in Verbindung steht und mit einem Kontaktbereich zur elektrischen Kontaktierung eines elektrischen Prüflings aus dem Stiftgehäuse herausragt. Es ist vorgesehen, dass die Federkontaktstiftanordnung einen Positionssensor aufweist, wobei das Kontaktelement zur Übertragung seines Hubs mit einem verlagerbaren Sensorelement des die Hubposition des Kontaktelements erfassenden Positionssensors in Verbindung steht.

### Beschreibung der Erfindung

Eine Aufgabe der Erfindung ist es, unter Einsatz konstruktiv möglichst einfacher Mittel eine Möglichkeit zur zuverlässigen Prüfung einer Position vielfältiger Komponenten eines Fahrzeugbauteils bereitzustellen. Es ist insbesondere die Aufgabe der vorliegenden Erfindung, eine Position von Steckkontakten elektrischer Steckverbinder oder von Sicherungen eines Sicherungskastens automatisch zu detektieren.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Ein erfindungsgemäßes Verfahren dient zum taktilen Erkennen einer jeweiligen Position von elektrisch leitfähigen Komponenten eines Fahrzeugbauteils. Ein zu prüfendes Fahrzeugbauteil wird lösbar in einem Prüfadapter einer Prüfstation befestigt. In einem ersten Schritt wird eine Prüfsonde der Prüfstation von einer Startposition in Richtung des zu prüfenden Fahrzeugbauteils bewegt. Dabei folgt die Prüfsonde einem vorgegebenen Weg in einer ersten Bewegungsrichtung. Die Prüfsonde stoppt, wenn ein Berührelement der Prüfsonde die elektrisch leitfähige Komponente des Fahrzeugbauteils berührt und dieses Berühren detektiert wird. Das Berührelement der Prüfsonde weist eine vordefinierte Überlappung zu der elektrisch leitfähigen Komponente auf. Die zum Zeitpunkt des Berührens erreichte erste Prüfposition der Prüfsonde wird bestimmt und zwischengespeichert. Im darauf folgenden Schritt wird die Prüfsonde von der erreichten ersten Prüfposition zurück in Richtung der Startposition zu einer definierten Rückfahrposition bewegt. Die zweite Bewegungsrichtung von der ersten Prüfposition hin zur Rückfahrposition ist also der ersten Bewegungsrichtung entgegengesetzt. Dabei bewegt sich die Prüfsonde auf dem vorgegebenen Weg. Nach erreichen der Rückfahrposition wird die Bewegungsrichtung der Prüfsonde abermals gewechselt und die Prüfsonde von der Rückfahrposition in der ersten Bewegungsrichtung bewegt, bis das Berührelement der Prüfsonde die elektrisch leitfähige Komponente des Fahrzeugbauteils erneut berührt und dieses Berühren erneut detektiert wird. D. h. die Prüfsonde stoppt erneut, wenn das Berührelement die elektrisch leitfähige Komponente des Fahrzeugbauteils berührt. Das Berührelement der Prüfsonde weist erneut die vordefinierte Überlappung zu der elektrisch leitfähigen Komponente auf. Die zum Zeitpunkt des erneuten Berührens erreichte zweite Prüfposition der Prüfsonde wird bestimmt und zwischengespeichert. Daraufhin wird die Prüfsonde wieder der zweiten Bewegungsrichtung von der zweiten Prüfposition Weg von den zu prüfenden Fahrzeugbauteil gefahren, bis die Prüfsonde die Startposition erreicht, und somit ein nächstes Bauteil durch erneutes ausführen des beschriebenen Verfahrens geprüft werden kann.

Zum Abschluss des Verfahrens zum taktilen Erkennen der Position mindestens einer elektrisch leitfähigen Komponente des Fahrzeugbauteils wird in einem Schritt des Vergleichens die erste Prüfposition mit einem ersten Sollwert oder einen um den ersten Sollwert definierten ersten Toleranzbereich verglichen. Zusätzlich oder alternativ wird im Schritt des Vergleichens die zweite Prüfposition mit dem ersten Sollwert, einem um den ersten Sollwert definierten ersten Toleranzbereich oder mit einem um die erste Prüfposition vordefinierten zweiten Toleranzbereich verglichen. Zusätzlich oder alternativ wird im Schritt des Vergleichens einer Differenz zwischen der ersten Prüfposition und der zweiten Prüfposition mit einem vordefinierten dritten Toleranzbereich verglichen. Solange die überprüften Werte, d. h. die erste Prüfposition, die zweite Prüfposition und/oder die Differenz der ersten und der zweiten Prüfposition innerhalb der vor definierten Toleranzbereiche liegen oder einen tolerierten Wert von dem für den Vergleich herangezogenen ersten Sollwert abweichen, ist die überprüfte elektrisch leitfähige Komponente des Fahrzeugbauteils korrekt und es wird keine Fehlerinformation bereitgestellt.

Die hier genannten Toleranzbereiche sind letztlich abhängig von der zu prüfenden elektrisch leitfähigen Komponente des Fahrzeugbauteils und den Fertigungstoleranzen dessen. Aus den Fertigungstoleranzen und den systembedingten Toleranzen der Prüfstation ergeben sich letztlich die hier definierten drei Toleranzbereiche. Die Toleranzbereiche können sich über wenige Hundertstel Millimeter oder wenige Zehntel Millimeter erstrecken. In seltenen Fällen sind auch Toleranzbereiche, die sich über einen oder wenige Millimeter erstrecken denkbar.

Durch das zweimalige Anfahren der elektrisch leitfähigen Komponente des Fahrzeugbauteils kann ein ungewolltes Verschieben der elektrisch leitfähigen Komponente innerhalb des Fahrzeugbauteils erkannt werden, wenn die erste Prüfposition und die zweite Prüfposition mehr als eine zulässige Toleranz voneinander abweichen. In einem idealen System müssten die erste Prüfposition und die zweite Prüfposition identisch sein. Somit ist die Größe des dritten Toleranzbereichs einerseits von der Genauigkeit der Positionserfassung der Prüfsonde als auch zusätzlich von der tolerierten Beweglichkeit der elektrisch leitfähigen Komponente innerhalb des Fahrzeugbauteils abhängig. Dies erlaubt beispielsweise einen indirekten Test beispielsweise sowohl einer primären, als auch einer sekundären Verrastung eines Kontaktteils in einem Steckergehäuse.

Um die Prüfzeit des zu prüfenden Fahrzeugbauteils zu verkürzen können verschiedene Wegstrecken der Prüfsonde mit unterschiedlichen Geschwindigkeiten durchfahren werden. So kann bei Bewegungen der Prüfsonde außerhalb des Fahrzeugbauteils mit hohen Geschwindigkeiten gearbeitet werden, um Zeit einzusparen, und beim Anfahren des Berührelements der Prüfsonde an die elektrisch leitfähige Komponente des Fahrzeugbauteils eine geringere Geschwindigkeit gewählt werden. Hierzu kann angepasst an das zu prüfende Fahrzeugbauteil eine erste Zwischenposition definiert werden, sodass die Prüfsonde zwischen der Startposition und der ersten Zwischenposition mit einer ersten Geschwindigkeit bewegt werden kann und zwischen der ersten Zwischenposition und der ersten Prüfposition oder der zweiten Prüfposition mit einer zweiten Geschwindigkeit bewegt werden kann, wobei die erste Geschwindigkeit schneller als die zweite Geschwindigkeit ist. So kann es sich bei der ersten Geschwindigkeit um eine Höchstgeschwindigkeit zum Bewegen der Prüfsonde handeln.

Nach dem Anfahren der ersten Prüfposition kann sich die Prüfsonde bei der Rückfahrt bis zur Rückfahrposition mit der zweiten Geschwindigkeit, also der langsameren der beiden Geschwindigkeiten, bewegen. Gleiches gilt für das Anfahren der zweiten Prüfposition.

Nach dem Anfahren der zweiten Prüfposition wird die Prüfsonde wieder zurück zur Startposition bewegt. Auch hier kann wieder die Prüfsonde mit zwei unterschiedlichen Geschwindigkeiten bewegt werden. So kann die Prüfsonde außerhalb des Fahrzeugbauteils mit der höheren Geschwindigkeit, d. h. der zweiten Geschwindigkeit, bewegt werden. So kann die Prüfsonde zwischen der zweiten Prüfposition und einer zweiten Zwischenposition mit der zweiten Geschwindigkeit bewegt werden, und zwischen der zweiten Zwischenposition und der Startposition mit der ersten Geschwindigkeit bewegt werden. Dabei kann die zweite Zwischenposition Position gleich zur ersten Zwischenposition und ergänzend oder Alternativposition gleich zur Rückfahrposition sein.

Die erste Zwischenposition kann mit einem Sicherheitsabstand zu dem zu prüfenden Fahrzeugbauteil definiert werden. Da nach dem anfahren der ersten Prüfposition die Position des Fahrzeugbauteils bekannt ist, können für die Rückfahrposition sowie für die zweite Zwischenposition, die auch auf eine Position zusammenfallen können, Positionen gewählt werden, die einen geringeren Abstand zu dem zu prüfenden Fahrzeugbauteil aufweisen.

Letztlich wird parallel zum Bewegen der Prüfsonde kontinuierlich überwacht, ob zumindest ein Berührelement der Prüfsonde eine Komponente des Fahrzeugbauteils berührt, um bei Detektion des Berührens die Bewegung der Prüfsonde zu stoppen.

Die erste Geschwindigkeit und die zweite Geschwindigkeit können nahtlos ineinander übergehen, sodass die Bewegung der Prüfsonde abgebremst oder beschleunigt wird, wobei in dem Bewegungsraum außerhalb des Fahrzeugbauteils die letztlich gefahrene Geschwindigkeit einen direkten Einfluss auf die Prüfzeit aufweist, jedoch für den Prüfvorgang an sich unerheblich ist. Die zweite Geschwindigkeit, die auch als Prüfgeschwindigkeit bezeichnet werden kann, kann auch als eine Maximalgeschwindigkeit betrachtet werden. Wie dargestellt, wird die zweite Geschwindigkeit derart gewählt, dass eine Beschädigung des zu prüfenden Fahrzeugbauteils ausgeschlossen oder zumindest vermieden werden kann. Auch geben Hersteller von elektrisch leitenden Komponenten für Fahrzeugbauteil teilweise eine maximale Geschwindigkeit zum kontaktieren dieser elektrisch leitenden Komponenten vor.

In einer Ausführungsform weist das zu prüfende Fahrzeugbauteil eine Vielzahl von elektrisch leitenden Komponenten auf. In diesem Fall ist es von Vorteil, wenn die Prüfsonde eine entsprechende Anzahl von Berührelementen in aufweist, um die Vielzahl von elektrisch leitenden Komponenten in einem Prüfdurchlauf parallel zu testen. In diesem Szenario werden die erste Prüfposition sowie die zweite Prüfposition für jedes einzelne Berührelement einzelnen erfasst und weiterverarbeitet.

Eine erfindungsgemäße Prüfstation dient zum taktilen Erkennen einer jeweiligen Position von Komponenten eines Fahrzeugbauteils und weist auf: einen Prüfadapter zur Aufnahme des zu prüfenden Fahrzeugbauteils, eine auf einem vorgegebenen Weg gegen den Prüfadapter bewegbare Prüfsonde, welche Prüfsonde mindestens ein Berührelement aufweist, mittels dessen eine Berührung mit der zu prüfenden Komponente des Fahrzeugbauteils detektierbar ist und einen Antrieb zum Bewegen der Prüfsonde und/oder des Prüfadapters, und die Prüfstation dazu eingerichtet ist, eine Wegposition der Prüfsonde und/oder des Prüfadapters bei einer Berührung mit mindestens einem Berührelement zu bestimmen.

Die Prüfstation weist eine Steuereinrichtung und eine Auswerteeinrichtung auf. Die Steuereinrichtung ist eingerichtet, den Antrieb derart anzusteuern, dass die Prüfsonde von einer Startposition auf dem vorgegebenen Weg in einer ersten Bewegungsrichtung in Richtung des zu prüfenden Fahrzeugbauteils bewegbar ist, wobei die Steuereinrichtung weiterhin eingerichtet ist, die Bewegung der Prüfsonde zu stoppen sobald ein Berührelement der Prüfsonde eine elektrisch leitende Komponente des Fahrzeugbauteils berührt und dieses Berühren entsprechend erfasst und ausgewertet wird. Hierzu ist die Steuereinrichtung mit der Auswerteeinrichtung gekoppelt. Die Auswerteeinrichtung ist ausgebildet eine erste Prüfposition der Prüfsonde zum Zeitpunkt des Berührens zu bestimmen. Die Steuereinrichtung ist weiterhin eingerichtet, den Antrieb derart anzusteuern dass die Prüfsonde von der ersten Prüfposition in einer zweiten Bewegungsrichtung, die der ersten Bewegungsrichtung entgegengesetzt ist, zurück in Richtung der Startposition auf dem vorgegebenen Weg bis zu einer Rückfahrposition bewegt wird. Weiterhin ist die Steuereinrichtung eingerichtet, den Antrieb derart anzusteuern dass die Prüfsonde von der Rückfahrposition in der ersten Bewegungsrichtung bewegt wird, bis das Berührelement der Prüfsonde die Komponente des Fahrzeugbauteils erneut berührt und dieses Berühren detektiert wird. Die Auswerteeinrichtung wiederum ist ausgebildet, eine zweite Prüfposition der Prüfsonde zum Zeitpunkt des erneuten Berührens zu bestimmen. Die Steuereinrichtung ist weiterhin ausgebildet, den Antrieb derart anzusteuern dass die Prüfsonde in der zweiten Bewegungsrichtung von der zweiten Prüfposition hin zur Startposition bewegt wird. Weiterhin weist die Prüfstation eine Vergleichseinrichtung auf welche die erfasste Prüfposition, d. h. die erste Prüfposition und die zweite Prüfposition auswertet und mit entsprechenden Sollwerten wie dies bereits oben im Detail erläutert ist, vergleicht, um ein Fehlersignal, welches eine Fehlerinformation repräsentiert, bereitzustellen. Letztlich bilden die Steuereinrichtung, die Auswerteeinrichtung sowie die Vergleichseinrichtung eine Einheit, welche ausgebildet ist Schritte des oben detaillierter beschriebenen Verfahrens zum taktilen Erkennen einer Position mindestens einer Komponente eines Fahrzeugbauteils auszuführen.

Der Antrieb kann auf verschiedene Art und Weise realisiert werden. So kann der Antrieb elektrisch, pneumatischen als auch hydraulisch erfolgen. Dabei ist erforderlich, dass die Bewegung direkt angesteuert wird und jederzeit gestoppt werden kann. Dies kann sowohl durch einen elektromotorischen Antrieb, einen Position-geregelten pneumatischen Antrieb als auch durch einen geregelten hydraulischen Antrieb erfolgen. Bei dem elektromotorischen Antrieb kann es sich sowohl um einen Schrittmotor, einen sehr wo Motor als auch um einen Linearantrieb handeln.

Ein elektromotorischer Antrieb kann insbesondere im Vergleich zu einem klassischen hydraulischen oder pneumatischen Antrieb den Vorteil aufweisen, dass durch den elektromotorischen Antrieb die Prüfsonde über ihren gesamten Verfahrweg mit hoher Variabilität (z.B. mit einer vorgegebenen, auch zeitlich änderbaren Geschwindigkeit und/oder Kraft) bewegbar ist und zudem ihre Position entlang des Verfahrwegs ("Wegposition") mit hoher Genauigkeit bestimmbar ist. Damit lässt sich eine Wegposition bei Berührung eines Berührelements genau bestimmen, woraus wiederum ein korrekter Sitz o.ä. der geprüften Komponente erkennbar ist. Ferner sind die mechanischen Kontaktbedingungen (Aufprallkraft usw.) präzise einstellbar. Darüber hinaus ermöglicht die Verwendung eines Elektromotors einen besonders einfachen, robusten und wartungsarmen Aufbau. Außerdem ist die Verwendung eines Elektromotors besonders energiesparend, insbesondere im Vergleich zu einem hydraulischen oder pneumatischen Antrieb.

Unter einem taktilen Erkennen einer Position einer Komponente wird insbesondere ein durch Berühren dieser Komponente bewirktes Ändern und Auswerten mindestens einer Messgröße verstanden, insbesondere einer Messgröße des Berührelements selbst. Es ist eine Weiterbildung, dass die Messgröße eine mechanische Messgröße ist, z.B. eine Verschiebung oder Verformung des Berührelements, ein Auslösen eines Schalters usw. Es ist eine alternative oder zusätzliche Weiterbildung, dass die Messgröße eine elektrische Messgröße ist, z.B. ein zwischen dem Berührelement und der Komponente fließender Strom.

Der Weg kann beispielsweise durch eine Führung vorgegeben sein. Eine Bewegung gegen den Prüfadapter kann auch als eine Bewegung in Richtung des Prüfadapters oder auf den Prüfadapter zu bezeichnet werden.

Das Bewegen der Prüfsonde und/oder des Prüfadapters kann umfassen, dass die Prüfsonde verfahrbar und der Prüfadapter stationär ist, dass die Prüfsonde stationär und der Prüfadapter verfahrbar ist oder dass sowohl die Prüfsonde als auch der Prüfadapter verfahrbar sind.

Die Prüfsonde kann ein oder mehrere Berührelemente aufweisen. Die Berührelemente können insbesondere in einer zu der durch sie zu prüfenden Komponenten ähnlichen Anordnung oder Struktur angeordnet sein, z.B. matrixförmig.

Dass der elektromotorische Antrieb zum zumindest schrittweisen Bewegen der Prüfsonde und/oder des Prüfadapters ausgebildet ist, kann umfassen, dass die Prüfsonde und/oder der Prüfadapter durch den Antrieb schrittartig oder kontinuierlich bewegbar sind. Der elektromotorische Antrieb kann ein Schrittmotor sein. Der elektromotorische Antrieb kann auch ein bürstenloser Gleichstrommotor sein. Grundsätzlich ist die Art des elektromotorischen Antriebs nicht beschränkt.

Die Prüfstation kann zum Bestimmen der Wegposition der Prüfsonde und/oder des Prüfadapters bei Berührung eine Auswerteeinrichtung aufweisen. Die Auswerteeinrichtung kann einen Speicher zum Speichern mindestens einer Wegposition aufweisen oder mit einem solchen Speicher gekoppelt sein.

Die Art der zu prüfenden Komponente ist grundsätzlich nicht beschränkt und kann z.B. Anschlagteile in einem Gehäuse, Relais und Sicherungen in einer Box, Halteteile, elektrische Kontakte usw. umfassen.

Es ist eine Ausgestaltung, dass mindestens ein Berührelement in Form eines elektrisch leitfähigen Steckkontakts vorliegt und die Prüfstation (z.B. deren Auswerteeinrichtung) dazu eingerichtet ist, einen elektrischen Kontakt des Steckkontakts zu detektieren. Dies ergibt den Vorteil, dass ein Kontakt bzw. die dem Kontakt entsprechende Wegposition besonders präzise detektierbar ist. Das Detektieren kann ein Detektieren eines Vorliegens eines durch den Steckkontakt fließenden elektrischen Stroms umfassen. Ist ein Kontakt gegeben, fließt ein Strom, sonst nicht. Diese Ausgestaltung ist besonders vorteilhaft zum Prüfen der Position von Kontaktelementen elektrischer Verbindungselemente. Es ist eine Weiterbildung, dass mindestens ein Berührelement als ein Steckkontakt in Form eines Stifts vorliegt, insbesondere falls die damit zu prüfende Komponente eine Buchse ist, in die der Stift einsteckbar ist. Es ist eine alternative oder zusätzliche Weiterbildung, dass mindestens ein Berührelement als ein Steckkontakt in Form einer Buchse vorliegt, insbesondere falls die damit zu prüfende Komponente ein Stift ist, der in die Buchse einsteckbar ist. Der elektrische Kontakt kann dem mechanischen Kontakt entsprechen bzw. an der gleichen Wegposition auftreten.

Es ist noch eine Ausgestaltung, dass mindestens ein Berührelement dazu eingerichtet ist, einen mechanischen Anschlag des Berührelements zu detektieren. Dadurch können die Positionen elektrisch leitfähiger und elektrisch nicht leitfähiger Komponenten durch Kontakt mit dem Berührelement zuverlässig detektiert werden. Ein solches Berührelement kann auch als ein berührungsempfindlicher Sensor bezeichnet werden.

Es ist eine weitere Ausgestaltung, dass die Prüfstation dazu eingerichtet ist, den mechanischen Anschlag eines Berührelements anhand einer Schaltung eines Schalters zu detektieren. Dies ermöglicht einen besonders genauen, kompakten und robusten Aufbau. Der Schalter kann in das Berührelement integriert sein. Es ist eine Weiterbildung, dass mindestens ein Berührelement ein berührungsempfindlicher Taster oder Schaltstift, insbesondere Schaltstiftschließer oder Schaltstiftöffner, ist.

Es ist noch eine weitere Ausgestaltung, dass die Prüfstation dazu eingerichtet ist, den mechanischen Anschlag des mindestens einen Berührelements anhand einer Motorstromaufnahme zu detektieren. So kann auf eine Verwendung berührungsempfindlicher Berührelemente verzichtet werden, was einen besonders preiswerten, kompakten und robusten Aufbau erlaubt. Bei dieser Ausgestaltung wird ausgenutzt, dass dann, wenn die Prüfsonde mit mindestens einem Berührelement auf eine zu prüfende Komponente trifft, die zu prüfende Komponente einer Weiterbewegung der Prüfsonde einen Widerstand entgegensetzt. Die Prüfsonde wird daher einen Motorstrom des elektromotorischen Antriebs automatisch erhöhen, um eine vorgegebene, insbesondere gleichbleibende Geschwindigkeit der Prüfsonde aufrechtzuerhalten. Ein plötzlicher Anstieg des Motorstroms kann also auf eine Berührung hindeuten.

Es ist eine Weiterbildung, dass die Prüfstation dazu eingerichtet ist, den mechanischen Anschlag des mindestens einen Berührelements mittels eines Wegmesssystems zu detektieren. Das Wegmesssystem kann z.B. eine Kontraktion des Berührelements detektieren.

Es ist ferner eine Ausgestaltung, dass die Prüfsonde entlang eines Gestänges verfahrbar ist. So wird ein besonders robuster und stabiler und preiswerter Aufbau ermöglicht.

Es ist auch eine Ausgestaltung, dass die Prüfsonde eine entlang des Gestänges verfahrbare Platte aufweist, an der das mindestens eine Berührelement angeordnet ist. So wird eine besonders gleichmäßige Verfahrung mehrerer nebeneinander auf der Platte angeordneter Berührelemente ermöglicht. Auch ist ein solcher Aufbau besonders einfach justierbar.

Es ist eine Weiterbildung, dass die Prüfsonde durch eine mittels eines Elektromotors antreibbare Antriebsspindel bewegbar ist. Dies ergibt den Vorteil, dass eine präzise Linearbewegung der Prüfsonde mittels einer besonders großen Auswahl an Elektromotoren bewirkbar ist.

Es ist außerdem eine Ausgestaltung, dass mindestens einem Berührelement ein optischer Farbsensor zugeordnet ist. Dies ermöglicht eine Typerkennung einer farbkodierten zu prüfenden Komponente. Die Prüfstation - z.B. deren Auswerteeinrichtung - kann dann dazu eingerichtet sein, eine Sollposition der zu prüfenden Komponente anhand ihrer Farbkodierung zu erkennen. So können vorteilhafterweise auch vor Prüfbeginn unbekannte Positionen farbkodierter Komponenten geprüft werden. Dies ist besonders vorteilhaft, wenn das zu prüfende Fahrzeugbauteil ein Sicherungskasten oder eine Sicherungsbank ist, und die zu prüfenden Komponenten farbkodierte Stecksicherungen oder Relais sind, weil solche Stecksicherungen oder Relais entsprechend ihrer Farbkodierung unterschiedliche Höhen aufweisen können.

Es ist eine Weiterbildung, dass eine Verfahrgeschwindigkeit der Prüfsonde variierbar ist. Dies ergibt - beispielsweise im Gegensatz zu einem hydraulischen oder pneumatischen Antrieb - den Vorteil, dass ein schneller Prüfablauf mit einer besonders genauen Messung der Wegposition kombinierbar ist.

Es ist auch noch eine Ausgestaltung, dass die Prüfsonde auf mindestens eine vorgegebene Wegposition verfahrbar ist. So kann eine besonders vielfältige Relativbewegung von Prüfsonde und Prüfadapter bzw. dem zu prüfenden Fahrzeugbauteil erreicht werden.

Es ist zudem eine Ausgestaltung, dass die Prüfstation dazu eingerichtet ist, aus der bei Berührung mittels des mindestens einen Berührungselements bestimmten Wegposition eine Abweichung zu einer Sollposition der zu prüfenden Komponente zu ermitteln und für den Fall, dass eine Abweichung zu der Sollposition für mindestens ein Berührelement oder eine zu prüfende Komponente einen vorgegebenen Schwellwert erreicht oder überschreitet, eine Meldung an einen Nutzer der Prüfstation auszugeben. Dies ergibt den Vorteil, dass falsch positionierte (z.B. zu weit vorstehende) Komponenten des Fahrzeugbauteils zuverlässig erkennbar sind und ein Nutzer die Möglichkeit erhält, bestimmte Aktionen auszulösen, z.B. das Fahrzeugbauteil zu untersuchen, zu reparieren oder als Ausschuss zu entsorgen. Zusätzlich oder alternativ können bestimmte Aktionen automatisch durch die Prüfstation ausgelöst oder durchgeführt werden.

Die Prüfstation kann dazu mit einer Auswerteeinrichtung ausgerüstet oder gekoppelt sein. Die Auswerteeinrichtung kann ein Rechner sein, auf dem ein entsprechendes Computerprogrammprodukt gespeichert ist. Der Rechner kann ein Industrierechner, Personal Computer, Laptop oder Tablet usw. sein, auf dem ein entsprechendes Auswerteprogramm gespeichert ist.

Die Auswerteeinrichtung kann einen Bildschirm aufweisen oder mit einem Bildschirm gekoppelt sein und dazu eingerichtet sein, zumindest die nicht korrekt positionierten Komponenten anzuzeigen. Insbesondere können alle zu prüfenden Komponenten bildlich angezeigt werden, wobei nicht korrekt positionierte Komponenten hervorgehoben anzeigbar sind, z.B. mittels einer farblichen und/oder blinkenden Hervorhebung.

Die Aufgabe wird auch gelöst durch ein System mit einer Prüfstation wie oben beschrieben und mit einem in bzw. an dem Prüfadapter befestigten zu prüfenden Fahrzeugbauteil. Das System kann analog zu dem Prüfadapter weitergebildet werden und ergibt die gleichen Vorteile.

Es ist eine Ausgestaltung, dass das zu prüfende Fahrzeugbauteil ein elektrisches Steckverbindungselement mit mehreren elektrischen Kontakten ist und die Prüfsonde mehrere Berührelemente in Form von zu den elektrischen Kontakten des Steckverbindungselements passenden mechanischen und/oder elektrischen Gegenkontakten aufweist. Die Kontakte können als Stifte und die Gegenkontakte als Buchsen ausgebildet sein, oder umgekehrt. Unter einem mechanischen Gegenkontakt kann insbesondere ein Gegenkontakt verstanden werden, mittels dessen eine Berührung aufgrund seiner mechanischen Änderung detektierbar ist, z.B. aufgrund einer Verformung, Verschiebung eines Kontaktkopfs, Biegung usw. Unter einem mechanischen Gegenkontakt kann insbesondere ein Gegenkontakt verstanden werden, mittels dessen eine Berührung nur aufgrund einer elektrischen Änderung detektierbar ist, z.B. aufgrund einer Strom- oder Spannungsänderung. Es sind auch Mischformen möglich.

Es ist noch eine Ausgestaltung, dass das zu prüfende Fahrzeugbauteil ein elektrischer Sicherungskasten bzw. Sicherungsbank mit mehreren elektrischen Sicherungen ist, die Prüfsonde mehrere Berührelement in Form von Anschlagelementen aufweist, denen jeweils ein optischer Farbsensor zugeordnet ist und die Prüfstation dazu eingerichtet ist, eine korrekte Position der Sicherungen abhängig von einer jeweils erkannten Farbe der Sicherungen zu erkennen. Die optischen Farbsensoren sind insbesondere an der Prüfsonde befestigt, z.B. neben einem zugeordneten Berührelement.

Es ist eine Ausgestaltung, dass das zu prüfende Fahrzeugbauteil ein elektrisches Steckverbindungselement mit mehreren elektrischen Kontakten ist und die Prüfsonde mehrere Berührelement in Form von zu den elektrischen Kontakten des Steckverbindungselements passenden mechanischen und/oder elektrischen Gegenkontakten aufweist, bei dem die Prüfsonde auf das zu prüfende Fahrzeugbauteil bewegt wird, bis eine vorgegebene Streckenlänge durchfahren ist oder eine weitere Bewegung verhindert wird, bei dem dann, wenn ein Berührelement eine Komponente des Fahrzeugbauteils berührt, diese Berührung mechanisch und/oder elektrisch detektiert wird und bei dem die Wegpositionen für alle Berührungen zwischen jeweiligen Kontakten und Gegenkontakten detektiert werden. Dadurch können die Positionen der einzelnen elektrischen Kontakte genau bestimmt werden, z.B. auch bezüglich einer Soll-Position.

### Kurze Figurenbeschreibung

Nachfolgend wird ein vorteilhaftes Ausführungsbeispiel der Erfindung unter Bezugnahme auf die begleitenden Figuren erläutert. Es zeigen:
- Fig. 1: als Schnittdarstellung in Seitenansicht ein erfindungsgemäßes System mit einer Prüfstation und mit einem an der Prüfstation angebrachten zu prüfenden Fahrzeugbauteil;
- Fig. 2: das erfindungsgemäße System in einer Schrägansicht;
- Fig. 3: einen Ablaufplan eines Verfahrens zum taktilen Erkennen einer Position einer Komponente gemäß einem Ausführungsbeispiel der vorliegenden Erfindung;
- Fig. 4: einen Ausschnitt der Prüfstation gemäß einem Ausführungsbeispiel der vorliegenden Erfindung; und
- Fig. 5: eine Systemdarstellung von Prüfstation, Steuerrechner und zentraler Speichereinrichtung gemäß einem Ausführungsbeispiel der vorliegenden Erfindung.

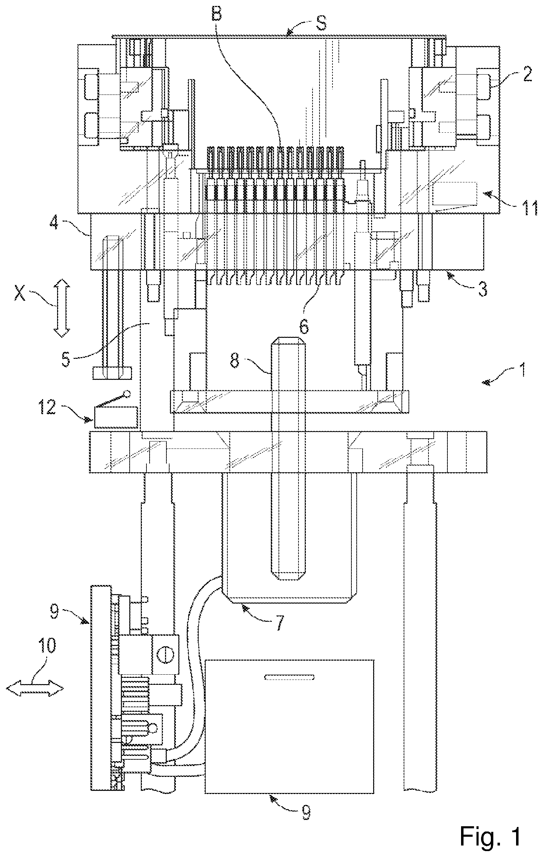

Figur 1 zeigt als Schnittdarstellung in Seitenansicht ein Prüfsystem 1, S mit einer Prüfstation 1 und mit einem zu prüfenden Fahrzeugbauteil in Form eines elektrischen Steckverbindungselements S. Das Steckverbindungselement S ist an einem Prüfadapter 2 der Prüfstation 1 angebracht oder verbaut, hier beispielsweise nach einem Einstecken verschraubt und/oder verriegelt.

Die Prüfstation 1 ist zum taktilen Erkennen einer jeweiligen Position mehrerer Komponenten des Steckverbindungselements S, nämlich elektrischen Kontakten in Form von Buchsen B eingerichtet. Die Prüfstation 1 weist dazu eine auf einem vorgegebenen Weg x gegen den Prüfadapter 2 bewegbare Prüfsonde 3 auf. Die Prüfsonde 3 weist eine steife, zumindest annähernd plattenförmige Basis 4 auf, die entlang eines Gestänges in Form einer Führungsstange 5 verfahrbar ist.

An einer dem Prüfadapter 2 zugewandten Seite sind an der Basis 4 mehrere Berührelemente in Form von z.B. Schaltstiftschließern 6 vorhanden. Die Schaltstiftschließer 6 sind so ausgebildet und angeordnet, dass sie bei einer ausreichenden Verfahrung entlang des Wegs x in Richtung des Prüfadapters 2 in die Buchsen B einfahren können. Nach Kontakt bzw. mit Beginn des Einfahrens des Schaltstiftschließers 6 in die Buchse B wird in dem Schaltstiftschließer 6 eine elektrische Verbindung geschlossen, was sich elektrisch detektieren lässt, z.B. als eine plötzliche merkliche Spannungs- oder Stromänderung. Das Schließen der elektrischen Verbindung kann auch als ein Schalten eines integrierten Schalters verstanden werden. Da die Schaltstiftschließer 6 stiftartige Köpfe aufweisen, mittels dessen sie in die Buchsen B einsteckbar sind, können die Schaltstiftschließer 6 auch als mechanische bzw. mechanisch detektierende Gegenkontakte in Form von mechanischen Kontaktstiften zu den Buchsen B verstanden werden. Mittels des Schaltstiftschließers 6 ist also dessen Berührung, insbesondere Anschlag, mit der zu prüfenden Buchse B detektierbar.

Die Prüfstation 1 weist einen Antrieb in Form eines elektrischen Schrittmotors 7 zum Bewegen oder Verfahren der Prüfsonde 3 (alternativ: des Prüfadapters 2 oder von beidem) auf. Der Schrittmotor 7 treibt eine Gewindespindel 8 an, welche auch in die Basis 4 eingreift und die Basis 4 linear entlang des Wegs x bewegen kann.

Der Schrittmotor 7 ist mit einer Motorsteuerung 9 verbunden, die wiederum mit einem Steuerrechner 10 verbunden ist oder verbunden werden kann. Dieser Aufbau ermöglicht es, dass eine Weglänge, eine Verfahrgeschwindigkeit und/oder eine Kraft der Prüfsonde 3 grundsätzlich beliebig einstellbar sind. Dies kann z.B. einfach über eine entsprechende datentechnische Einrichtung des Steuerrechners 10 erfolgen, wodurch sich auch ein Aufwand für eine Justierung erheblich verringert. Es können mittels des Steuerrechners 10 auch Weg-, Geschwindigkeits- und/oder Kraft-Rampen zum Verfahren der Prüfsonde 3 eingestellt werden. Grundsätzlich können beliebig viele Wegpositionen abgefahren werden. Bei großen und/oder schweren Prüfsonden können diese allgemein durch mehrere Motoren antreibbar sein.

Der Steuerrechner 10, z.B. ein Personal Computer oder ein Laptop, kann mit einer Datenbank gekoppelt sein oder eine Datenbank in einem Datenspeicher gespeichert aufweisen. Der Steuerrechner 10 kann aber auch fest in der Prüfstation 1 integriert sein. In der Datenbank können für bestimmte Fahrzeugbauteile passende Verfahrwerte oder Verfahrabläufe der Prüfsonde 3 zentral erfasst sein. Auch kann aus der Datenbank eine Vielzahl verschiedener Werte abgefragt werden, z.B. verschiedene Wegpositionen, Kraftaufwand, elektrischer Durchgang bei bestimmten Positionen usw.

Auch ein Schalten der Schaltstiftschließer 6 kann z.B. von dem Steuerrechner 10 erfasst bzw. detektiert und ausgewertet werden. Der Steuerrechner 10 kann also auch als eine Auswerteeinrichtung zum Auswerten der Berührungen der Schaltstiftschließer 6 dienen. Die Prüfstation 1 ist insbesondere mittels des Steuerrechners 10 dazu eingerichtet, eine Wegposition der Prüfsonde 3 bei einer Berührung mindestens eines Schaltstiftschließers 6 zu bestimmen und zu speichern. Der Steuerrechner 10 kann einen Bildschirm aufweisen oder mit einem Bildschirm gekoppelt sein und dazu eingerichtet sein, zumindest nicht korrekt positionierte Schaltstiftschließer 6 anzuzeigen.

Außerdem kann der Steuerrechner 10 in seiner Eigenschaft als Auswerteeinrichtung aus dem Datenpaar Berührung / Wegposition eine Abweichung zu einer Sollposition einer Buchse B ermitteln und für den Fall, dass eine Abweichung zu der Sollposition für mindestens einen Schaltstiftschließer 6 bzw. Buchse B einen vorgegebenen Schwellwert erreicht oder überschreitet, eine Meldung an einen Nutzer der Prüfstation 1 ausgeben. Zusätzlich oder alternativ können bestimmte Aktionen automatisch durch die Prüfstation ausgelöst oder durchgeführt werden, z.B. ein Reversieren der Bewegungsrichtung der Prüfsonde 3, ein Ausgeben eines optischen und/oder akustischen Warnhinweises, ein Speichern in einer Datenbank usw.

Allgemein kann die Prüfsonde 3 bis zu einer Endposition bewegt werden, die - wie gezeigt - einem geschlossenen Zustand zwischen Prüfsonde 3 und Steckverbindungselement S entspricht. Zum Unterbrechen des Motors 7 mit Erreichen dieser ("oberen") Endposition kann ein erster Endschalter 11 an dem Prüfadapter 2 vorhanden sein. Analog kann ein zweiter Endschalter 12 an der Prüfstation 1 vorhanden sein, um den Motor 7 mit Erreichen einer entgegengesetzten ("unteren") Endposition stromlos zu schalten. In der gezeigten oberen Endposition sind alle Schaltstiftschließer 6 in die zugehörigen Buchsen B eingesteckt.

Die Figuren sind lediglich schematische Darstellungen und dienen nur der Erläuterung der Erfindung.

So kann in einer Variante jedem Schaltstiftschließer 6 ein optischer Farbsensor zugeordnet sein, um eine Farbe der durch diesen Schaltstiftschließer 6 kontaktierten Komponente zu erfassen. Dies ist beispielsweise vorteilhaft, wenn die zu prüfenden Komponenten Sicherungen und/oder Relais eines Sicherungskastens o.ä. sind. Dann kann z.B. mittels des Steuerrechners 10 eine korrekte Position der Sicherungen abhängig von ihrer jeweils erkannten Farbe überprüft werden. Die Köpfe der Schaltstiftschließer 6 können insbesondere auch in diesem Fall abgeflacht und/oder verbreitert sein, um eine besonders zuverlässige Kontaktierung zu ermöglichen.

Die Prüfstation 1 ist in dem beschriebenen Ausführungsbeispiel mit einem Schrittmotor sieben als Antrieb ausgeführt. Als Antrieb kann alternativ auf verschiedene elektrische, pneumatische oder hydraulische Antriebe zurückgegriffen werden. Als elektrischer Antrieb kann auch alternativ ein positionsgesteuerter Servus Antrieb oder Linearantrieb eingesetzt werden. Für den Anwender ergeben sich durch den Einsatz der unterschiedlichen Antriebsarten letztlich keine großen Änderungen, sofern die spezifischen Herausforderungen des jeweiligen Antriebs bei der Konstruktion und Ausführung der Prüfstation eins berücksichtigt werden. Dabei ist auf die Positionsgenauigkeit und die gesteuerte Ansteuerung des Antriebs abzuzielen, sodass, sobald eine Prüfposition erreicht wird, der Antrieb eine Bewegung des Prüfadapters 2 bzw. der Prüfsonde 3 stoppt.

Gleiche oder gleichwirkende Elemente sind durchgängig mit den gleichen Bezugszeichen versehen.

Der Prüfablauf soll hier noch mal mit anderen Worten dargestellt werden. Der Prüfling (z.B. Steckergehäuse) wird in den Prüfadapter (in einer Prüfstation verbaut) gesteckt. Sobald der Prüfling (z.B. Steckergehäuse) vollständig eingelegt ist, werden die Verriegelungen über einen Schaltstift aktiviert und halten den Prüfling (z.B. Steckergehäuse) fest. Der Prüfling (z.B. Steckergehäuse) wird auf den Taschenboden des Prüfadapters gedrückt und ist somit spielfrei fixiert. Durch ein Startsignal wird der Prüfablauf gestartet. Die verfahrbare Ebene fährt durch den Antrieb, beispielsweise einem Schrittmotor (mit integriertem direkten oder indirekten Wegmesssystem), mit Eilgang in Richtung Prüfling (z.B. Steckergehäuse), bis die Berührelemente die unterste Ebene des Prüflings (z.B. Steckergehäuse) erreichen. Mit einem einstellbaren, langsamen Vorschub wird nun auf eine definierte Endposition (ermittelt durch eine Toleranzanalyse des Prüflings (z.B. Steckergehäuse und Kontaktteil)) gefahren. Während dieser Bewegung werden ständig die Berührelemente abgefragt (auf elektrischen Kontakt oder auf elektrischen Durchgang, je nach verwendetem Berührelement). Sobald ein Signal erkannt wird, kann über das direkte oder indirekte Wegmesssystem des Antriebs die genaue Position der zu prüfenden Bauteile (z.B. Kontaktteile) innerhalb des Prüflings (z.B. Steckergehäuse) bestimmt werden. Mittels Software kann ausgewertet werden, ob die bestimmten Positionen innerhalb eines voreingestellten Toleranzrahmens liegen. Daraus kann eine gut-schlecht Bewertung der Prüflings (z.B. Steckergehäuse) erfolgen. Während der gesamten restlichen Prüfungen an dem Prüfling (z.B. Steckergehäuse) können die Berührelemente innerhalb des Prüflings (z.B. Steckergehäuse) verbleiben (z.B. für elektrischen Kontakt). Die verfahrbare Ebene kann dabei entweder durch Dauerbestromung des Schrittmotors, durch eine zusätzlich angebrachte Bremse an der Gewindespindel oder durch eine Gewindespindel mit Selbsthemmung in der entsprechenden Position gehalten werden.

Nachdem alle notwendigen Prüfungen an dem Prüfling (z.B. Steckergehäuse) abgeschlossen sind, kann über ein Signal das Zurückfahren der Berührelemente und damit der verfahrbaren Ebene gestartet werden. Dies folgt zunächst langsam mit einem definierten Vorschub, bis die Berührelemente den Prüfling (z.B. Steckergehäuse) verlassen haben. Das restliche Zurückfahren erfolgt dann im Eilgang des Schrittmotors.

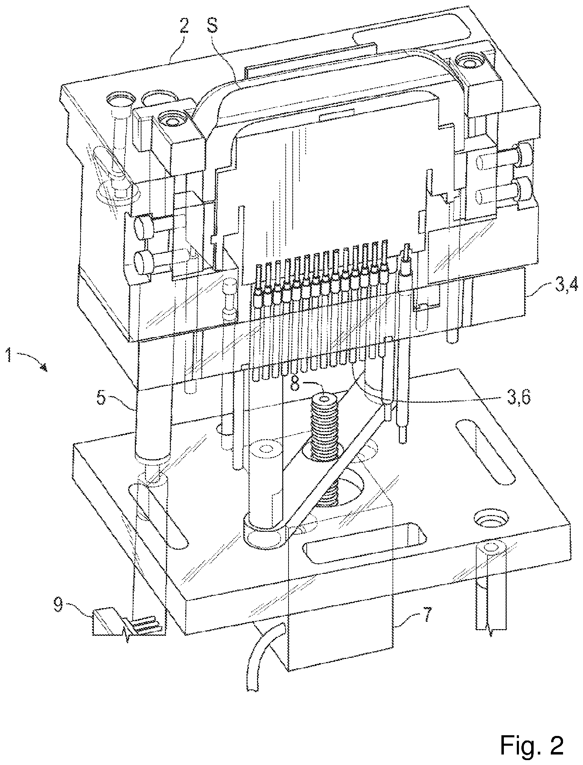

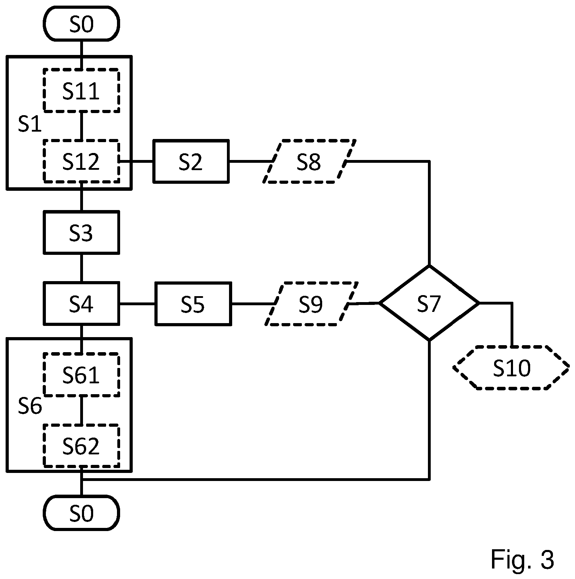

Fig. 3 zeigt einen Ablaufplan eines Verfahrens zum taktilen Erkennen einer Position mindestens einer leitfähigen Komponente B eines Fahrzeugbauteils S gemäß einem Ausführungsbeispiel der vorliegenden Erfindung. Dem leichteren Verständnis und zuordnende werden in der folgenden Beschreibung die in Fig. 1 und Fig. 2 verwendeten Bezugszeichen weiterhin verwendet. Das Verfahren weist eine Vielzahl von Verfahrensschritten auf, wovon einige optional durchgeführt werden können. Die in Fig. 1 und Fig. 2 dargestellte Prüfstation 1 ist eingerichtet, das hier beschriebene Verfahren auszuführen.

Das hier dargestellte und beschriebene Verfahren geht davon aus, dass die auf ihre Position zu prüfende Komponente B des Fahrzeugbauteils S lösbar an einem Prüfadapter zwei befestigt ist und ein entsprechendes Signal als Träger die Ausführung des dargestellten Verfahrens startet. In einem ersten Schritt S1 wird eine Prüfsonde 3 von einer Startposition auf einem vorgegebenen Weg X in einer ersten Bewegungsrichtung X₁ in Richtung des zu prüfenden Fahrzeugbauteils S bewegt, bis ein Berührelement der Prüfsonde 3 eine Komponente B des Fahrzeugbauteils es berührt und dieses Berühren detektiert wird. Daraufhin wird im darauf folgenden Schritt S2 eine erste Prüfposition der Prüfsonde drei zum Zeitpunkt des Berührens bestimmt. Dann wird in einem Schritt S3 die Prüfsonde drei von der ersten Prüfposition in einer zweiten Bewegungsrichtung zurück in Richtung der Startposition auf dem vorgegebenen Weg bis zu einer Rückfahrposition bewegt. Die Rückfahrposition liegt in der Regel zwischen der ersten Prüfposition und der Startposition.

Die darauf folgenden Schritte S4 und S5 ähneln den bereits durchgeführten Schritten S1 und S2. Im Schritt S4 wird die Prüfsonde drei von der Rückfahrposition in der ersten Bewegungsrichtung in Richtung des zu prüfenden Fahrzeugbauteils S bewegt bis ein Berührelement der Prüfsonde 3 die Komponente B des Fahrzeugbauteils S erneut berührt und dieses Berühren als zweite Prüfposition detektiert wird. Im Schritt S5 wird die zweite Prüfposition der Prüfsonde drei zum Zeitpunkt des erneuten Berührens bestimmt. Nach dem bestimmen der zweiten Prüfposition wird im Schritt S6 die Prüfsonde 3 in der zweiten Bewegungsrichtung von der zweiten Prüfposition hin zu der Startposition bewegt. Im Schritt S7 wird die erste Prüfposition mit einem ersten Sollwert oder einem um den ersten Sollwert vordefinierten ersten Toleranzbereich verglichen. Zusätzlich oder alternativ wird im Schritt S7 die zweite Prüfposition mit dem ersten Sollwert, mit einem um den ersten Sollwert vordefinierten ersten Toleranzbereich, mit einem um die erste Prüfposition vordefinierten zweiten Toleranzbereich verglichen. Zusätzlich oder alternativ wird im Schritt S7 eine Differenz zwischen der ersten Prüfposition und der zweiten Prüfposition mit einem vordefinierten dritten Toleranzbereich verglichen.

Optional kann der Schritt S1 in zwei Teilschritte S11 und S12 aufgeteilt werden, wodurch sich zusätzlich bei der Bewegung eine erste Zwischenposition ergibt. Im Schritt S11 wird die Prüfsonde 3 von der Startposition in der ersten Bewegungsrichtung bis zur ersten Zwischenposition mit einer ersten Geschwindigkeit bewegt und im Schritt S12 wird die Prüfsonde 3 mit einer zweiten Geschwindigkeit von der ersten Zwischenposition bis zur ersten Prüfposition bewegt. Dabei ist die erste Geschwindigkeit schneller wie die zweite Geschwindigkeit.

In gleicher Weise kann optional der Schritt S6 in zwei Teilschritte S61 und S62 aufgeteilt werden, wodurch sich zusätzlich bei der Bewegung der Prüfsonde 3 eine zweite Zwischenposition ergibt. Die zweite Zwischenposition kann identisch zur bereits beschriebenen Rückfahrposition sein. Dabei wird im Schritt S61 die Prüfsonde 3 von der zweiten Prüfposition in der zweiten Bewegungsrichtung mit der zweiten Geschwindigkeit bewegt. Im Schritt S62 wird die Prüfsonde 3 mit der ersten Geschwindigkeit von der zweiten Zwischenposition bis zur Startposition bewegt. Die erste und die zweite Geschwindigkeit können hier als maximal Geschwindigkeiten betrachtet werden wobei die erste Geschwindigkeit schneller wie die zweite Geschwindigkeit ist. Insbesondere in dem Streckenabschnitt, in dem die erste Geschwindigkeit gefahren wird, kann die Prüfsonde entsprechend beschleunigt und abgebremst werden, um dann nahtlos die Geschwindigkeit, mit der die Prüfsonde bewegt wird, in die zweite Geschwindigkeit übergehen zu lassen.

Bei dem in Fig. 3 dargestellten Ablaufdiagramm wird in Schritt S0 ein Signal empfangen, dass der Prüfling, d.h. das Fahrzeugbauteil S mit der Komponente B, fixiert oder verriegelt ist. Daraufhin erfolgt in Schritt S11 eine Annäherung der Berührelemente der Prüfsonde 3 mit Höchstgeschwindigkeit (erste Geschwindigkeit) bis zu einem minimalen Sicherheitsabstand zum Prüfling, d.h. bis zur ersten Zwischenposition Pzi. Im darauf folgenden Schritt S12 erfolgt ein langsames Einfahren der Berührelemente in den Kontaktbereich des Prüflings, optional bis zu einer gewünschten Überlappung. Ab hier gehen zwei Wege weiter, der Schritt S2 sowie der Schritt S3. Im Schritt S2 erfolgt ein Bestimmen der Kontaktposition (erste Prüfposition) des Prüflings durch kontinuierliches Abfragen der Berührelemente und eines Wegmesssystems. In der Praxis bedeutet dies, dass der Schritt S12 und der Schritt S2 in einem gewissen Rahmen parallel ausgeführt werden, um festzustellen, wann ein Berührelement der Prüfsonde 3 eine Komponente B des Fahrzeugbauteils S berührt und die Prüfposition P_{P1} zum Zeitpunkt des Berührens zu bestimmen. Im auf den Schritt S2 folgenden Schritt S8 werden die Daten der ersten Positionsbestimmung, d.h. die erste Prüfposition P_{P1} gespeichert. Im Schritt S3 fährt die Prüfsonde 3 mit den Berührelementen zurück, bis zu einem minimalen Sicherheitsabstand zum Prüfling, d.h. bis zur Rückfahrposition P_{R}. Auf den Schritt S3 folgt der Schritt S4 mit einem erneuten langsamen Einfahren der Berührelemente der Prüfsonde 3 in den Kontaktbereich des Prüflings bis zur gewünschten minimalen Überlappung von Berührelement der Prüfsonde 3 und Komponente B des Fahrzeugbauteils S. Auf den Schritt S4 folgen analog zu dem Schritt S12 wieder zwei Schritte, welche parallel ausgeführt werden können. So folgt auf den Schritt S4 sowohl der Schritt S5 als auch der Schritt S61. Im Schritt S5 erfolgt ein erneutes Bestimmen der Kontaktposition (zweite Prüfposition P_{P2}) des Prüflings durch kontinuierliches Abfragen der Berührelemente und des Wegmesssystems. Im Schritt S61 werden die Berührelemente oder besser ausgedrückt die Prüfsonde 3 mit den darin enthaltenen Berührelementen bis auf einen minimalen Sicherheitsabstand zum Prüfling, d.h. zur zweiten Zwischenposition P_{Z2}, zurückgefahren. Auf den Schritt S5 folgt der Schritt S9, in dem die Daten der zweiten Positionsbestimmung, d.h. die zweite Prüfposition P_{P2}, gespeichert werden. Auf den Schritt S61 folgt der Schritt S62. Im Schritt S62 wird die Prüfsonde 3 mit Höchstgeschwindigkeit, d.h. erste Geschwindigkeit, in die Ausgangslage, d.h. zur Startposition Ps, zurückgefahren. Auf die Schritte S8 und S9 folgt ein Schritt S7, in dem die beiden Datensätze, d.h. insbesondere die erste Prüfposition P_{P1} und die zweite Prüfposition P_{P2}, auf Veränderungen gegenüber vorgegebene Toleranzen verglichen werden und generell die bestimmten Positionen gegen vorgegebene Toleranzen verglichen werden. Das Ergebnis der Auswertung in Schritt S7 wird in einem auf Schritt S7 folgenden Schritt S10 an ein übergeordnetes System gesendet. Nachdem die Schritte S7 und S62 durchlaufen wurden, wird die Prüfung beendet und kann mit dem nächsten Prüfling wieder von vorne beginnen. In der Regel wird ein entsprechendes Endsignal bereitgestellt, um die Fixierung des Prüflings aufzuheben und diesen aus der Prüfstation entnehmen zu können.

Die Schritte S11 und S12 können zu einem Schritt S1 zusammengefasst werden. Analog können die Schritte S61 und S62 zu einem Schritt S6 zusammengefasst werden.

Wie bereits ausgeführt, wird das Berührelement der Prüfsonde 3 in der ersten Bewegungsrichtung X₁ bewegt, bis das Berührelement die Komponente berührt oder eine definierte Überlappung aufweist. Hierzu kann zwischen dem Schritt 1 und dem Schritt S3 oder alternativ als Teilschritt von Schritt S1 die Prüfsonde zumindest um eine vordefinierte Distanz weiter in der ersten Bewegungsrichtung X₁ bewegt werden, um eine vordefinierte Überlappung zwischen dem Berührelement und der Komponente B zu erzielen. Eine solche Überlappung weist den Vorteil auf, dass federnde Berührelemente einen eventuell nicht verrasteten Kontakt, d.h. Komponente B des Fahrzeugbautels S, wegschieben können und beim zweiten Messen des Kontaktpunktes, d.h. zweite Prüfpunkt P_{P2}, in so einem Fall eine unterschiedliche Position vorhanden ist. Ist der Kontakt ganz normal verrastet, so federt das Berührelement B um den Wert der Überlappung ein. Ist der Kontakt nicht verrastet, so wird der Kontakt um einen Teil der Überlappung verschoben, je nach benötigter Kraft. Der Wert der Überlappung ergibt sich aus der Kombination der Prüflinge und des verwendeten Berührelements.

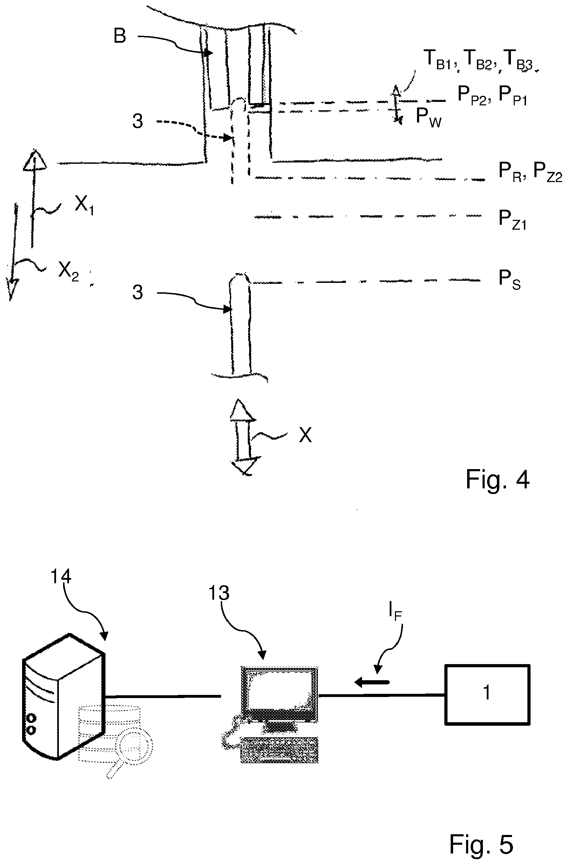

Fig. 4 zeigt in einer Detaildarstellung einen Ausschnitt der Prüfstation 1 gemäß einem Ausführungsbeispiel der vorliegenden Erfindung. Dargestellt ist eine Prüfsonde 3, welche verschiedene Positionen entlang eines vordefinierten Weges X anfahren kann, sowie eine Komponente B dargestellt. Dabei ist eine erste Bewegungsrichtung X₁ als von der Prüfsonde 3 in Richtung der Komponente B definiert, eine zweite Bewegungsrichtung X₂ ist als die zur ersten Bewegungsrichtung x₁ umgedrehte Richtung definiert. Zu Beginn befindet sich die Prüfsonde 3 in der Startposition Ps. Wenn die Prüfsonde 3 von der Startposition Ps in Richtung der Komponente B bis zur ersten Prüfposition P_{P1} bewegt wird, so bewegt sie sich an der ersten Zwischenposition P_{Z1} vorbei. Danach wird die Prüfsonde 3 zurück in der zweiten Bewegungsrichtung X₂ bis zur Rückfahrposition P_{R} bewegt, um dann wieder in der ersten Bewegungsrichtung X₁ in Richtung der Komponente B bis zur zweiten Prüfposition P_{P2} bewegt zu werden. Auf dem Rückweg von der zweiten Prüfposition P_{P2} zur Startposition Ps bewegt sich die Prüfsonde 3 über die zweite Zwischenposition P_{Z2}. Bei einem optimalen Prüfergebnis sind die erste Prüfposition P_{P1}, die zweite Prüfposition P_{P2} sowie ein Sollwert Sw identisch. In dem hier dargestellten Beispiel ist die Komponente B etwas zu tief angeordnet, sodass die Prüfsonde 3 an dem Sollwert Sw vorbei bewegt wird bis zur ersten Prüfposition P_{P1} und der in diesem Beispiel hierzu identischen zweiten Prüfposition P_{P2}. Wie bereits ausführlich in der Beschreibung zu Fig. 3 dargestellt sind verschiedene Toleranzbereiche definiert, wobei wenn die Prüfwerte außerhalb der Toleranzbereiche liegen, ein Fehler vorliegt. In dem hier dargestellten Beispiel entsprechen der erster Toleranzbereich T_{B1}, der zweite Toleranzbereich T_{B2} sowie der dritte Toleranzbereich T_{B3} einander, wobei alle drei in diesem Fall relativ zum Sollwert Sw liegen. Der Sollwert Sw wird teilweise auch als erster Sollwert Sw bezeichnet, da er einen direkten Bezug zum ersten Toleranzbereich T_{B}, aufweist, wohingegen der zweite Toleranzbereich T_{B2} sowie der dritte Toleranzbereich T_{B3} auch auf andere Werte bezogen sein können.

Fig. 5 zeigt eine schematische Darstellung einer Prüfstation 1, wie diese beispielsweise in Fig. 1 und Fig. 2 dargestellt ist, zusammen mit einem Steuerrechner 13 sowie einer zentralen Speichereinrichtung 14. Im beschriebenen Fehlerfall wird eine Fehlerinformation I_{F} bereitgestellt. In dem Steuerrechner 13 sind die Steuereinrichtung, die Auswerteeinrichtung sowie die Vergleichseinrichtung der Prüfstation 1 zusammengefasst. Die einzelnen Messergebnisse sowie die dazugehörige Auswertung können optional in der zentralen Speichereinrichtung 14 dauerhaft gespeichert werden und für weitergehende Datenauswertung genutzt werden. Hierbei können beispielsweise die Stichwörter "Big Data" und "Predictive Analytics" genannt werden, um auf diese Art und Weise vorausschauende Maßnahmen ähnlich einer vorausschauenden Wartung im Bereich der Fertigung durchführen zu können.

### BEZUGSZEICHENLISTE

- 1: Prüfstation
- 2: Prüfadapter
- 3: Prüfsonde
- 4: Basis
- 5: Führungsstange
- 6: Schaltstiftschließer
- 7: Antrieb, Schrittmotor
- 8: Gewindespindel
- 9: Motorsteuerung
- 10: Steuerrechner
- 11: Erster Endschalter
- 12: Zweiter Endschalter
- B: Komponente, Buchse
- S: Fahrzeugbauteil, Steckverbindungselement
- x: Weg

- I_{F}: Fehlerinformation
- P_{P1}: erste Prüfposition
- P_{P2}: zweite Prüfposition
- P_{R}: Rückfahrposition
- P_{S}: Startposition
- P_{Z1}: erste Zwischenposition
- P_{Z2}: zweite Zwischenposition
- Sw: erster Sollwert
- T_{B1}: erster Toleranzbereich
- T_{B2}: zweiter Toleranzbereich
- T_{B3}: dritter Toleranzbereich
- X₁: erste Bewegungsrichtung
- X₂: zweite Bewegungsrichtung

- 13: Steuerreichner
- 14: zentrale Speichereinrichtung

## Patentansprüche

1. Verfahren zum taktilen Erkennen einer Position mindestens einer elektrisch leitfähigen Komponente (B) eines Fahrzeugbauteils (S), bei dem ein zu prüfendes Fahrzeugbauteil (S) lösbar an einem Prüfadapter (2) befestigt wird, mit den folgenden Schritten:
- Bewegen (S1) einer Prüfsonde (3) von einer Startposition (P_{S}) auf einem vorgegebenen Weg (x) in einer ersten Bewegungsrichtung (X₁) in Richtung des zu prüfenden Fahrzeugbauteils (S), bis ein Berührelement der Prüfsonde (3) eine Komponente (B) des Fahrzeugbauteils (S) berührt und dieses Berühren detektiert wird;
- Bestimmen (S2) einer ersten Prüfposition (P_{P1}) der Prüfsonde (3) zum Zeitpunkt des Berührens;
- Bewegen (S3) der Prüfsonde (3) von der ersten Prüfposition (P_{P1}) in einer zweiten Bewegungsrichtung (X₂) zurück in Richtung der Startposition (P_{S}) auf dem vorgegebenen Weg (x) bis zu einer Rückfahrposition (P_{R});
- Bewegen (S4) der Prüfsonde (3) von der Rückfahrposition (P_{R}) in der ersten Bewegungsrichtung (X₁), bis das Berührelement der Prüfsonde (3) die Komponente (B) des Fahrzeugbauteils (S) erneut berührt und dieses Berühren detektiert wird;
- Bestimmen (S5) einer zweiten Prüfposition (P_{P2}) der Prüfsonde (3) zum Zeitpunkt des erneuten Berührens;
- Bewegen (S6) der Prüfsonde (3) in der zweiten Bewegungsrichtung (X₂) von der zweiten Prüfposition (P_{P2}) bis zu der Startposition (P_{S});
- Vergleichen (S7) der ersten Prüfposition (P_{P1}) mit einem ersten Sollwert (S_{W}) oder einem um den ersten Sollwert (S_{W}) vordefinierten ersten Toleranzbereich (T_{B1})
und/oder
Vergleichen der zweiten Prüfposition (P_{P2}) mit dem ersten Sollwert (S_{W}) oder mit einem um die erste Prüfposition (P_{P1}) vordefinierten zweiten Toleranzbereich (T_{B2})
und/oder
Vergleichen einer Differenz zwischen der ersten Prüfposition (P_{P1}) und der zweiten Prüfposition (P_{P2}) mit einem vordefinierten dritten Toleranzbereich (T_{B3}), wobei eine Fehlerinformation (I_{F}) bereitgestellt wird, wenn bei dem Vergleichen ein Ergebnis außerhalb eines der vordefinierten Toleranzbereiche (T_{B1}, T_{B2}, T_{B3}) liegt.

2. Verfahren nach Anspruch 1, bei dem im Schritt (S1) des Bewegens der Prüfsonde (3) von der Startposition (P_{S}) in der ersten Bewegungsrichtung (X₁) die Prüfsonde bis zu einer ersten Zwischenposition (P_{Z1}) mit einer ersten Geschwindigkeit bewegt wird und nach der ersten Zwischenposition (P_{Z1}) mit einer zur ersten Geschwindigkeit langsameren zweiten Geschwindigkeit bis zur ersten Prüfposition (P_{P1}) bewegt wird.

3. Verfahren nach Anspruch 1 oder 2 bei dem im Schritt (S1) des Bewegens der Prüfsonde (3) von der zweiten Prüfposition (P_{P2}) in der zweiten Bewegungsrichtung (X₂) die Prüfsonde (3) bis zu einer zweiten Zwischenposition (P_{Z2}) mit der zweiten Geschwindigkeit bewegt wird und nach der zweiten Zwischenposition (P_{Z2}) mit der zur zweiten Geschwindigkeit schnelleren ersten Geschwindigkeit bis zur Startposition (P_{S}) bewegt wird.

4. Verfahren nach Anspruch 2 oder 3, bei dem die erste Geschwindigkeit nahtlos in die zweite Geschwindigkeit abgebremst und/oder die zweite Geschwindigkeit in die erste Geschwindigkeit beschleunigt wird.

5. Verfahren nach einem der vorangegangenen Ansprüche, bei dem
- das zu prüfende Fahrzeugbauteil (S) ein elektrisches Steckverbindungselement mit mehreren elektrischen Kontakten (B) ist und die Prüfsonde (3) mehrere Berührelemente in Form von zu den elektrischen Kontakten (B) des Steckverbindungselements (S) passenden mechanischen oder elektrischen Gegenkontakten aufweist, bei dem
- die Prüfsonde (3) auf das zu prüfende Fahrzeugbauteil (S) bewegt wird, bis eine vorgegebene Streckenlänge durchfahren ist oder eine weitere Bewegung verhindert wird, bei dem
- dann, wenn ein Berührelement eine Komponente (B) des Fahrzeugbauteils (S) berührt, diese Berührung mechanisch und/oder elektrisch detektiert wird und bei dem die Wegpositionen für alle Berührungen zwischen jeweiligen Kontakten (B) und Gegenkontakten detektiert werden.

6. Prüfstation (1) zum taktilen Erkennen einer Position mindestens einer Komponente (B) eines Fahrzeugbauteils (S), aufweisend
- einen Prüfadapter (2) zur Aufnahme des zu prüfenden Fahrzeugbauteils (S);
- eine auf einem vorgegebenen Weg (x) gegen den Prüfadapter (2) bewegbare Prüfsonde (3);
- wobei die Prüfsonde (3) mindestens ein Berührelement aufweist, mittels dessen eine Berührung mit der zu prüfenden Komponente (B) des Fahrzeugbauteils (S) detektierbar ist; und
- einen Antrieb zum Bewegen der Prüfsonde (3) und/oder des Prüfadapters (2),
- wobei die Prüfstation (1) dazu eingerichtet ist, eine Wegposition der Prüfsonde (3) und/oder des Prüfadapters (2) bei einer Berührung mit mindestens einem Berührelement zu bestimmen;
- eine Steuereinrichtung, die eingerichtet ist, den Antrieb anzusteuern, um die Prüfsonde (3) von einer Startposition (P_{S}) auf dem vorgegebenen Weg (x) in einer ersten Bewegungsrichtung (X₁) in Richtung des zu prüfenden Fahrzeugbauteils (S) zu bewegen, bis ein Berührelement der Prüfsonde (3) eine Komponente (B) des Fahrzeugbauteils (S) berührt und dieses Berühren detektiert wird;
- eine Auswerteeinrichtung, die eingerichtet ist, eine ersten Prüfposition (P_{P1}) der Prüfsonde (3) zum Zeitpunkt des Berührens zu bestimmen;
- wobei die Steuereinrichtung eingerichtet ist, den Antrieb derart anzusteuern, um die Prüfsonde (3) von der ersten Prüfposition (P_{P1}) in einer zweiten Bewegungsrichtung (X₂) zurück in Richtung der Startposition (P_{S}) auf dem vorgegebenen Weg (x) bis zu einer Rückfahrposition (P_{R}/P₂) zu bewegen;
- und die Steuereinrichtung eingerichtet ist, den Antrieb derart anzusteuern, dass die Prüfsonde (3) von der Rückfahrposition (P_{R}) in der ersten Bewegungsrichtung (X₁) zu bewegen, bis das Berührelement der Prüfsonde (3) die Komponente (B) des Fahrzeugbauteils (S) erneut berührt und dieses Berühren detektiert wird;
- wobei die Auswerteeinrichtung eingerichtet ist, eine zweite Prüfposition (P_{P2}) der Prüfsonde (3) zum Zeitpunkt des erneuten Berührens zu bestimmen;
- und die Steuereinrichtung eingerichtet ist, den Antrieb derart anzusteuern, um die Prüfsonde (3) in der zweiten Bewegungsrichtung (X₂) von der zweiten Prüfposition (P_{P2}) bis zu der Startposition (P_{S}) zu bewegen;
- eine Vergleichseinrichtung zum Vergleichen (S9) der ersten Prüfposition (P_{P1}) mit einem ersten Sollwert (S_{W}) oder einem um den ersten Sollwert vordefinierten ersten Toleranzbereich (T_{B1})
und/oder
Vergleichen der zweiten Prüfposition (P_{P2}) mit dem ersten Sollwert oder mit einem um die erste Prüfposition (P_{P1}) vordefinierten zweiten Toleranzbereich (T_{B2})
und/oder
Vergleichen einer Differenz zwischen der ersten Prüfposition (P_{P1}) und der zweiten Prüfposition (P_{P2}) mit einem vordefinierten dritten Toleranzbereich (T_{B3}), wobei eine Fehlerinformation bereitgestellt wird, wenn bei dem Vergleichen ein Ergebnis außerhalb eines der vordefinierten Toleranzbereiche liegt.

7. Prüfstation nach Anspruch 6, wobei der Antrieb ein elektromotorischer Antrieb (7) zum zumindest schrittweisen Bewegen der Prüfsonde (3) und/oder des Prüfadapters (2) ist, oder der Antrieb ein positionsgeregelter pneumatischer Antrieb ist, oder der Antrieb ein hydraulischer Antrieb ist, oder der Antrieb ein geregelter Servoanatrieb ist, oder der Antrieb ein Linearmotor ist.

8. Prüfstation (1) nach Anspruch 7, wobei mindestens ein Berührelement in Form eines elektrisch leitfähigen Steckkontakts vorliegt und die Prüfstation (1) dazu eingerichtet ist, einen elektrischen Kontakt des Steckkontakts zu detektieren und/oder mindestens ein Berührelement dazu eingerichtet ist, einen mechanischen Anschlag des Berührelements zu detektieren.

9. Prüfstation (1) nach Anspruch 8, wobei die Prüfstation (1) dazu eingerichtet ist, den mechanischen Anschlag eines Berührelements anhand einer Schaltung eines Schalters zu detektieren oder die Prüfstation (1) dazu eingerichtet ist, den mechanischen Anschlag des mindestens einen Berührelements anhand einer Motorstromaufnahme zu detektieren.

10. Prüfstation (1) nach einem der Ansprüche 6 bis 9, wobei die Prüfsonde (3) entlang eines Gestänges (5) verfahrbar ist und die Prüfsonde (3) eine entlang des Gestänges (5) verfahrbare Platte (4) aufweist, an der das mindestens eine Berührelement angeordnet ist.

11. Prüfstation (1) nach einem der Ansprüche 6 bis 10, wobei mindestens einem Berührelement ein optischer Farbsensor zugeordnet ist.

12. Prüfstation (1) nach einem der Ansprüche 6 bis 11, wobei die Prüfstation (1) dazu eingerichtet ist, aus der bei Berührung mittels des mindestens einen Berührungselements (6) bestimmten Wegposition eine Abweichung zu einer Sollposition der zu prüfenden Komponente (B) zu ermitteln und für den Fall, dass eine Abweichung zu der Sollposition für mindestens ein Berührelement einen vorgegebenen Schwellwert erreicht oder überschreitet, eine Meldung an einen Nutzer der Prüfstation (1) auszugeben.

13. System (1, S) mit einer Prüfstation (1) nach einem der Ansprüche 6 bis 12 und einem in dem Prüfadapter (2) befestigten zu prüfenden Fahrzeugbauteil (S).

14. System (1, S) nach Anspruch 13, wobei das zu prüfende Fahrzeugbauteil (S) ein elektrisches Steckverbindungselement mit mehreren elektrischen Kontakten (B) ist und die Prüfsonde (3) mehrere Berührelemente in Form von zu den elektrischen Kontakten (B) des Steckverbindungselements (S) passenden mechanischen und/oder elektrischen Gegenkontakten aufweist.

15. System nach Anspruch 13, wobei das zu prüfende Fahrzeugbauteil (S) ein elektrischer Sicherungskasten mit mehreren elektrischen Sicherungen ist, die Prüfsonde (3) mehrere Berührelemente in Form von Anschlagelementen aufweist, denen jeweils ein optischer Farbsensor zugeordnet ist und die Prüfstation (1) dazu eingerichtet ist, eine korrekte Position der Sicherungen abhängig von einer jeweils erkannten Farbe der Sicherungen zu erkennen.

## Claims

1. Method for the tactile detection of a position of at least one electrically conductive component (B) of a vehicle part (S), in which a vehicle part (S) to be tested is releasably secured to a test adapter (2), comprising the following steps:
- moving (S1) a test probe (3) from a starting position (P_{S}) on a predefined path (x) in a first movement direction (X₁) in the direction of the vehicle part (S) to be tested until a contact element of the test probe (3) makes contact with a component (B) of the vehicle part (S) and this contact is detected;
- determining (S2) a first test position (P_{P1}) of the test probe (3) at the time of contact;
- moving (S3) the test probe (3) from the first test position (P_{P1}) in a second movement direction (X₂) back in the direction of the starting position (Ps) on the predefined path (x) up to a return position (P_{R});
- moving (S4) the test probe (3) from the return position (P_{R}) in the first movement direction (X₁) until the contact element of the test probe (3) contacts the component (B) of the vehicle part (S) again and this contact is detected;
- determining (S5) a second test position (P_{P2}) of the test probe (3) at the time of renewed contact;
- moving (S6) the test probe (3) in the second movement direction (X₂) from the second test position (P_{P2}) to the starting position (Ps);
- comparing (S7) the first test position (P_{P1}) with a first setpoint value (Sw) or a predefined first tolerance range (T_{B1}) around the first setpoint value (Sw)
and/or
comparing the second test position (P_{P2}) with the first setpoint value (Sw) or with a predefined second tolerance range (T_{B2}) around the first test position (P_{P1})
and/or
comparing a difference between the first test position (P_{P1}) and the second test position (P_{P2}) with a predefined third tolerance range (T_{B3}),
wherein a piece of error information (I_{F}) is provided when a result is outside of one of the predefined tolerance ranges (T_{B1}, T_{B2}, T_{B3}) in the comparison.

2. Method according to Claim 1, wherein, in the step (S1) of moving the test probe (3) from the starting position (Ps) in the first movement direction (X₁), the test probe is moved to a first intermediate position (P_{Z1}) at a first speed and is moved after the first intermediate position (P_{Z1}) to the first test position (P_{P1}) at a second speed which is slower than the first speed.

3. Method according to Claim 1 or 2, wherein, in the step (S1) of moving the test probe (3) from the second test position (P_{P2}) in the second movement direction (X₂), the test probe (3) is moved to a second intermediate position (P_{Z2}) at the second speed and is moved after the second intermediate position (P_{Z2}) to the starting position (P_{S}) at the first speed which is quicker than the second speed.

4. Method according to Claim 2 or 3, wherein the first speed is braked smoothly to the second speed and/or the second speed is accelerated into the first speed.

5. Method according to one of the preceding claims, wherein
- the vehicle part (S) to be tested is an electrical plug-in connection element comprising a plurality of electrical contacts (B) and the test probe (3) has a plurality of contact elements in the form of mechanical or electrical mating contacts which correspond to the electrical contacts (B) of the plug-in connection element (S), wherein
- the test probe (3) is moved onto the vehicle part (S) to be tested until a predefined section length has been covered or a further movement is prevented, wherein,
- when a contact element makes contact with a component (B) of the vehicle part (S), this contact is detected mechanically and/or electrically and wherein the travel positions for all of the instances of contact between respective contacts (B) and mating contacts are detected.

6. Test station (1) for the tactile detection of a position of at least one component (B) of a vehicle part (S), said test station comprising:
- a test adapter (2) for receiving the vehicle part (S) to be tested;
- a test probe (3) which can be moved counter to the test adapter (2) along a predefined path (x);
- wherein the test probe (3) has at least one contact element by means of which it is possible to detect contact with the component (B) to be tested of the vehicle part (S); and
- a drive for moving the test probe (3) and/or the test adapter (2),
- wherein the test station (1) is set up to determine a travel position of the test probe (3) and/or of the test adapter (2) upon making contact with at least one contact element;
- a control device which is set up to control the drive in order to move the test probe (3) from a starting position (P_{S}) on the predefined path (x) in a first movement direction (X₁) in the direction of the vehicle part (S) to be tested until a contact element of the test probe (3) makes contact with a component (B) of the vehicle part (S) and this contact is detected;
- an evaluation device which is set up to determine a first test position (P_{P1}) of the test probe (3) at the time of the contact;
- wherein the control device is set up to control the drive in such a way as to move the test probe (3) from the first test position (P_{P1}) in a second movement direction (X₂) back in the direction of the starting position (P_{S}) on the predefined path (x) up to a return position (P_{R}/P₂);
- and the control device is set up to control the drive in such a way as to move the test probe (3) from the return position (P_{R}) in the first movement direction (X₁) until the contact element of the test probe (3) makes contact with the component (B) of the vehicle part (S) again and this contact is detected;
- wherein the evaluation device is set up to determine a second test position (P_{P2}) of the test probe (3) at the time of the renewed contact;
- and the control device is set up to control the drive in such a way as to move the test probe (3) in the second movement direction (X₂) from the second test position (P_{P2}) to the starting position (P_{S});
- a comparison device for comparing (S9) the first test position (P_{P1}) with a first setpoint value (S_{W}) or a predefined first tolerance range (T_{B1}) around the first setpoint value
and/or
comparing the second test position (P_{P2}) with the first setpoint value or with a predefined second tolerance range (T_{B2}) around the first test position (P_{P1})
and/or
comparing a difference between the first test position (P_{P1}) and the second test position (P_{P2}) with a predefined third tolerance range (T_{B3}),
wherein a piece of error information is provided when a result is outside of one of the predefined tolerance ranges in the comparison.

7. Test station according to Claim 6, wherein the drive is an electromotive drive (7) for moving the test probe (3) and/or the test adapter (2) at least in steps, or the drive is a position-controlled pneumatic drive, or the drive is a hydraulic drive, or the drive is a controlled servo drive, or the drive is a linear motor.

8. Test station (1) according to Claim 7, wherein at least one contact element is present in the form of an electrically conductive plug-in contact and the test station (1) is set up to detect electrical contact of the plug-in contact and/or at least one contact element is set up to detect mechanical impact of the contact element.

9. Test station (1) according to Claim 8, wherein the test station (1) is set up to detect the mechanical impact of a contact element based on switching of a switch or the test station (1) is set up to detect the mechanical impact of the at least one contact element based on a motor current recording.

10. Test station (1) according to one of Claims 6 to 9, wherein the test probe (3) can be moved along a linkage system (5) and the test probe (3) has a plate (4) which can be moved along the linkage system (5) and on which the at least one contact element is arranged.

11. Test station (1) according to one of Claims 6 to 10, wherein an optical colour sensor is assigned to at least one contact element.

12. Test station (1) according to one of Claims 6 to 11, wherein the test station (1) is designed to ascertain a deviation from a target position of the component (B) to be tested from the travel position determined by means of the at least one contact element (6) making contact and, if a deviation from the target position for at least one contact element reaches or exceeds a predetermined threshold value, to output a notification to a user of the test station (1).

13. System (1, S) comprising a test station (1) according to one of Claims 6 to 12 and a vehicle part (S) to be tested and secured in the test adapter (2).

14. System (1, S) according to Claim 13, wherein the vehicle part (S) to be tested is an electrical plug-in connection element comprising a plurality of electrical contacts (B) and the test probe (3) has a plurality of contact elements in the form of mechanical and/or electrical mating contacts which correspond to the electrical contacts (B) of the plug-in connection element (S) .

15. System according to Claim 13, wherein the vehicle part (S) to be tested is an electrical fuse box comprising a plurality of electrical fuses, the test probe (3) has a plurality of contact elements in the form of impact elements to which a respective optical colour sensor is assigned, and the test station (1) is set up to identify a correct position of the fuses depending on a respectively identified colour of the fuses.

## Revendications

1. Procédé de reconnaissance tactile d'une position d'au moins un composant électriquement conducteur (B) d'une pièce de véhicule (S), dans lequel une pièce de véhicule (S) à contrôler est fixée de manière amovible à un adaptateur de contrôle (2), comprenant les étapes suivantes consistant à :
- déplacer (S1) une sonde de contrôle (3) d'une position de départ (P_{S}) sur une course prédéfinie (x) dans un premier sens de mouvement (X₁) en direction de la pièce de véhicule (S) à contrôler jusqu'à ce qu'un élément de contact de la sonde de contrôle (3) entre en contact avec un composant (B) de la pièce de véhicule (S) et que ce contact soit détecté ;
- déterminer (S2) une première position de contrôle (P_{P1}) de la sonde de contrôle (3) au moment du contact ;
- ramener (S3) la sonde de contrôle (3) de la première position de contrôle (P_{P1}) dans un deuxième sens de mouvement (X₂) en direction de la position de départ (Ps) sur la course prédéfinie (x) jusqu'à une position de retour (P_{R}) ;
- déplacer (S4) la sonde de contrôle (3) de la position de retour (P_{R}) dans le premier sens de mouvement (X₁) jusqu'à ce que l'élément de contact de la sonde de contrôle (3) entre à nouveau en contact avec le composant (B) de la pièce de véhicule (S) et que ce contact soit détecté ;
- déterminer (S5) une deuxième position de contrôle (P_{P2}) de la sonde de contrôle (3) au moment du nouveau contact ;
- déplacer (S6) la sonde de contrôle (3) dans le deuxième sens de mouvement (X₂) de la deuxième position de contrôle (P_{P2}) jusqu'à la position de départ (P_{S}) ;
- comparer (S7) la première position de contrôle (P_{P1}) avec une première valeur de consigne (S_{W}) ou une première plage de tolérance prédéfinie (T_{B1}) autour de la première valeur de consigne (Sw),
et/ou
comparer la deuxième position de contrôle (P_{P2}) avec la première valeur de consigne (Sw) ou avec une deuxième plage de tolérance prédéfinie (T_{B2}) autour de la première position de contrôle (P_{P1}),
et/ou
comparer une différence entre la première position de contrôle (P_{P1}) et la deuxième position de contrôle (P_{P2}) avec une troisième plage de tolérance prédéfinie (T_{B3}), une information d'erreur (I_{F}) étant fournie si lors de la comparaison un résultat se trouve en dehors d'une des plages de tolérance prédéfinies (T_{B1,} T_{B2}, T_{B3}).

2. Procédé selon la revendication 1, dans lequel à l'étape (S1) du déplacement de la sonde de contrôle (3) de la position de départ (P_{S}) dans le premier sens de mouvement (X₁), la sonde de contrôle est déplacée jusqu'à une première position intermédiaire (P_{Z1}) à une première vitesse, et après la première position intermédiaire (P_{Z1}) à une deuxième vitesse plus lente par rapport à la première vitesse jusqu'à la première position de contrôle (P_{P1}).

3. Procédé selon la revendication 1 ou 2, dans lequel à l'étape (S1) du déplacement de la sonde de contrôle (3) de la deuxième position de contrôle (P_{P2}) dans le deuxième sens de mouvement (X₂), la sonde de contrôle (3) est déplacée jusqu'à une deuxième position intermédiaire (P_{Z2}) à la deuxième vitesse, et après la deuxième position intermédiaire (P_{Z2}) à la première vitesse plus rapide par rapport à la deuxième vitesse jusqu'à la position de départ (P_{S}).

4. Procédé selon la revendication 2 ou 3, dans lequel la première vitesse est décélérée en continu jusqu'à la deuxième vitesse, et/ou la deuxième vitesse est accélérée jusqu'à la première vitesse.

5. Procédé selon l'une quelconque des revendications précédentes, dans lequel
- la pièce de véhicule (S) à contrôler est un élément de connexion enfichable électrique pourvu de plusieurs contacts électriques (B), et la sonde de contrôle (3) présente plusieurs éléments de contact sous la forme de contre-contacts mécaniques ou électriques assortis aux contacts électriques (B) de l'élément de connexion enfichable (S), dans lequel
- la sonde de contrôle (3) est déplacée vers la pièce de véhicule (S) à contrôler jusqu'à ce qu'une longueur de course prédéfinie ait été parcourue ou qu'un mouvement supplémentaire soit empêché, dans lequel,
- lorsqu'un élément de contact entre en contact avec un composant (B) de la pièce de véhicule (S), ce contact est détecté de manière mécanique et/ou électrique, et dans lequel les positions de course sont détectées pour tous les contacts entre des contacts (B) et contre-contacts respectifs.

6. Station de contrôle (1) de reconnaissance tactile d'une position d'au moins un composant (B) d'une pièce de véhicule (S), présentant
- un adaptateur de contrôle (2) servant à recevoir la pièce de véhicule (S) à contrôler ;
- une sonde de contrôle (3) pouvant être déplacée contre l'adaptateur de contrôle (2) sur une course prédéfinie (x) ;
- la sonde de contrôle (3) présentant au moins un élément de contact au moyen duquel un contact avec le composant (B) à contrôler de la pièce de véhicule (S) peut être détecté ; et
- un dispositif d'entraînement pour déplacer la sonde de contrôle (3) et/ou l'adaptateur de contrôle (2),
- la station de contrôle (1) étant conçue pour déterminer une position de course de la sonde de contrôle (3) et/ou de l'adaptateur de contrôle (2) lors d'un contact avec au moins un élément de contact ;
- un dispositif de commande qui est conçu pour piloter le dispositif d'entraînement pour déplacer la sonde de contrôle (3) d'une position de départ (Ps) sur la course prédéfinie (x) dans un premier sens de mouvement (X₁) en direction de la pièce de véhicule (S) à contrôler jusqu'à ce qu'un élément de contact de la sonde de contrôle (3) entre en contact avec un composant (B) de la pièce de véhicule (S) et que ce contact soit détecté ;
- un dispositif d'évaluation qui est conçu pour déterminer une première position de contrôle (P_{P1}) de la sonde de contrôle (3) au moment du contact ;
- le dispositif de commande étant conçu pour piloter le dispositif d'entraînement de façon à ramener la sonde de contrôle (3) de la première position de contrôle (P_{P1}) dans un deuxième sens de mouvement (X₂) en direction de la position de départ (Ps) sur la course prédéfinie (x) jusqu'à une position de retour (P_{R}/P₂) ;
- et le dispositif de commande est conçu pour piloter le dispositif d'entraînement de façon à déplacer la sonde de contrôle (3) de la position de retour (P_{R}) dans le premier sens de mouvement (X₁) jusqu'à ce que l'élément de contact de la sonde de contrôle (3) entre à nouveau en contact avec le composant (B) de la pièce de véhicule (S) et que ce contact soit détecté ;
- le dispositif d'évaluation étant conçu pour déterminer une deuxième position de contrôle (P_{P2}) de la sonde de contrôle (3) au moment du nouveau contact ;
- et le dispositif de commande est conçu pour piloter le dispositif d'entraînement de façon à déplacer la sonde de contrôle (3) dans le deuxième sens de mouvement (X₂) de la deuxième position de contrôle (P_{P2}) jusqu'à la position de départ (P_{S}) ;
- un dispositif de comparaison servant à comparer (S9) la première position de contrôle (P_{P1}) avec une première valeur de consigne (Sw) ou une première plage de tolérance prédéfinie (T_{B1}) autour de la première valeur de consigne,
et/ou
comparer la deuxième position de contrôle (P_{P2}) avec une première valeur de consigne ou avec une deuxième plage de tolérance prédéfinie (T_{B2}) autour de la première position de contrôle (P_{P1}),
et/ou
comparer une différence entre la première position de contrôle (P_{P1}) et la deuxième position de contrôle (P_{P2}) avec une troisième plage de tolérance prédéfinie (T_{B3}), une information d'erreur étant fournie si lors de la comparaison un résultat se trouve en dehors d'une des plages de tolérance prédéfinies.

7. Station de contrôle selon la revendication 6, dans laquelle le dispositif d'entraînement est un dispositif d'entraînement électromoteur (7) servant au déplacement au moins pas-à-pas de la sonde de contrôle (3) et/ou de l'adaptateur de contrôle (2), ou le dispositif d'entraînement est un dispositif d'entraînement pneumatique régulé en position, ou le dispositif d'entraînement est un dispositif d'entraînement hydraulique, ou le dispositif d'entraînement est un servomoteur régulé ou le dispositif d'entraînement est un moteur linéaire.

8. Station de contrôle (1) selon la revendication 7, dans laquelle au moins un élément de contact est présent sous la forme d'un contact enfichable électriquement conducteur, et la station de contrôle (1) est conçue pour détecter un contact électrique du contact enfichable, et/ou au moins un élément de contact est conçu pour détecter une mise en butée mécanique de l'élément de contact.

9. Station de contrôle (1) selon la revendication 8, dans laquelle la station de contrôle (1) est conçue pour détecter la mise en butée mécanique d'un élément de contact à l'aide d'un circuit d'un commutateur, ou la station de contrôle (1) est conçue pour détecter la mise en butée mécanique du au moins un élément de contact à l'aide de la puissance absorbée du moteur.

10. Station de contrôle (1) selon l'une quelconque des revendications 6 à 9, dans laquelle la sonde de contrôle (3) est coulissante le long d'une tringlerie (5), et la sonde de contrôle (3) présente une plaque coulissante (4) le long de la tringlerie (5) sur laquelle est disposé ledit au moins un élément de contact.

11. Station de contrôle (1) selon l'une quelconque des revendications 6 à 10, dans laquelle un capteur de couleur optique est associé à au moins un élément de contact.

12. Station de contrôle (1) selon l'une quelconque des revendications 6 à 11, dans laquelle la station de contrôle (1) est conçue pour établir à partir de la position de course déterminée lors du contact au moyen du au moins un élément de contact (6) un écart par rapport à une position de consigne du composant (B) à contrôler, et au cas où un écart par rapport à la position de consigne pour au moins un élément de contact atteindrait ou dépasserait une valeur seuil prédéfinie, pour émettre une notification à destination d'un utilisateur de la station de contrôle (1).

13. Système (1, S) comprenant une station de contrôle (1) selon l'une quelconque des revendications 6 à 12 et une pièce de véhicule (S) à contrôler, fixée dans l'adaptateur de contrôle (2).

14. Système (1, S) selon la revendication 13, dans lequel la pièce de véhicule (S) à contrôler est un élément de connexion enfichable électrique pourvu de plusieurs contacts électriques (B), et la sonde de contrôle (3) présente plusieurs éléments de contact sous la forme de contre-contacts mécaniques ou électriques assortis aux contacts électriques (B) de l'élément de connexion enfichable (S).

15. Système selon la revendication 13, dans lequel la pièce de véhicule (S) à contrôler est un coffret à fusibles électriques pourvu de plusieurs fusibles électriques, la sonde de contrôle (3) présente plusieurs éléments de contact sous la forme d'éléments de butée auxquels respectivement un capteur de couleur optique est associé, et la station de contrôle (1) est conçue pour reconnaître une position correcte des fusibles en fonction d'une couleur des fusibles respectivement reconnue.
